# EUROPEAN PATENT SPECIFICATION

(11) **EP 1 936 697 B1**
(45) Date of publication and mention of the grant of the patent: **09.03.2016**
(21) Application number: 07150279.3
(22) Date of filing: 20.12.2007
(51) Int. Cl.: H01L 29/778, H01L 29/78, H01L 21/336, H01L 21/338

(54) **A field effect transistor device, and methods of production thereof**
Feldeffekttransistorvorrichtung und Herstellungsverfahren dafür
Dispositif à transistor à effet de champ et ses procédés de production

(30) Priority: 22.12.2006 EP 06127148
(43) Date of publication of application: 25.06.2008
(73) Proprietor: IMEC, 3001 Leuven (BE)
(72) Inventor: Heyns, Marc, 3210 Linden (BE); Meuris, Marc, 3140 Keerbergen (BE)
(74) Representative: Pronovem

(56) References cited:
- JP-A- 63 124 473
- US-A- 4 556 895
- US-A1- 2004 115 916
- US-A1- 2005 035 369
- US-A1- 2005 035 470
- US-A1- 2006 228 863

## Description

### Field of the Invention

The present invention is related to a method for producing a semiconductor transistor device, e.g. a metal-oxide semiconductor field-effect transistor (MOSFET) or High Electron Mobility Transistor (HEMT), using semiconductor materials such as III-V materials (e.g. GaAs), preferably III-V materials with a high bandgap (>1eV), and Ge, in order to create a device with improved capabilities.

### State of the Art

The use of Ge, SiₓGe₁₋ₓ and of III-V materials such as GaAs, is known in the production of semiconductor devices. These materials have superior characteristics in terms of the mobility of charge carriers (electrons or holes), which makes them highly suitable for the production of improved FET devices.

However, a number of problems have been acknowledged, in particular in relation to the use of III-V materials in CMOS technology. Ion implantation of GaAs for example is not an easy operation, due to the difficulty of annealing out the defects, after the ion bombardment of a GaAs area. Another problem is the contacting of III-V materials. On GaAs and other similar materials, it is difficult to obtain low resistive contacts, and complex metallization schemes have to be used.

Document US5036374 highlights problems involved with the use of III-V materials or Ge in MOSFET devices, mainly in relation to the difficulty of providing a high quality dieletric on the channel layer. A MOSFET is proposed with a channel, source and drain in GaAs, and with a single crystal Si thin film between the channel and the dielectric. One embodiment suggests a GaAs or Ge channel in combination with Si source and drain areas, however with the channel being produced by Metal-Organic Chemical Vapour Deposition (MOCVD) or Molecular Layer Epitaxy (MLE) on top of a Si substrate comprising said source and drain areas.

Document JP62266873 is related to a HEMT device wherein Ge layers are used to block incident light on an AlGaAs electron supplying layer. Ge layers are supplied at the upper and lower parts of the AlGaAs layer. In the abovecited documents, heterojunctions are oriented horizontally, thereby limiting the extent to which the gate is able to control during operation of the device the heterojunction energy barrier properties, due to the spacing between the gate dielectric and the heterojunction. Document US 2005/0035369 describes a transistor comprising SiGe source and drain regions and a III/V channel.

### Aims of the Invention

The present invention aims to provide a semiconductor transistor device, such as a MOSFET or HEMT which provides a solution for the problems identified above.

### Summary of the Invention

The invention is related to devices and methods such as described in the appended claims. Preferred embodiments of the device and method of the invention are disclosed in combinations of the independent claims with one or more of the dependent claims.

The invention is related to a semiconductor transistor device, provided with a source and drain area produced in or on a semiconductor substrate, more particularly in or on a so-called 'active area' of a substrate, which is delimited by field areas (field oxides/dielectric areas).

The invention is related to a semiconductor transistor device according to claim 1.

According to a first embodiment, said areas are provided in a substrate and said substrate comprises a top layer of said III-V material, and two openings are present in said top layer, and said openings have been filled with SiGe, to form said source and drain areas.

According to a second embodiment, said areas are provided in a substrate and said substrate comprises a top layer of SiₓGe₁₋ₓ, and an opening is present in said top layer, and said opening has been filled with III-V material, to form said channel area.

Said III-V material may be chosen from the group consisting of GaAs, AlP, GaP, AlAs, InGaNAs, InGaAs, InP and AlSb.

Said source and/or drain area may be provided with a contact portion consisting of a metal germanide and/or silicide.

Said device may be a MOSFET or a HEMT.

The invention is equally related to a method for producing a device according to the invention, said method comprising the steps of :
- providing a substrate having a top layer consisting of a III-V material,
- By a photolithographic technique, etching back two cavities in the III-V layer, to form a channel area in between said cavities,
- Filling up said cavities with SiGe, to form source and drain areas in contact with the channel area

According to a second embodiment, a method for producing a device of the invention is provided, said method comprising the steps of :
- providing a substrate having a top layer consisting of SiGe,
- By a photolithographic technique, etching back a cavity in the SiGe layer, for forming a channel area,
- Filling up said cavity with III-V material, to form the channel area.

In the above, a 'III-V substrate' and a 'SiGe' substrate' can be substrates made of such materials, or substrates comprising a top layer of such materials.

According to one embodiment, x is smaller than 100%. According to other embodiments, x is - respectively - smaller than 90%, 80% and 70%.

The device equally comprises a gate electrode, preferably provided with a gate dielectric between the gate electrode and the channel layer. According to the invention, the heterojunctions are oriented so as to intersect, i.e. be in physical contact with the gate dielectric or with the gate electrode (when no gate dielectric is present). According to the invention, said heterojunctions are not parallel to the plane of the substrate in which the areas are provided, said plane being defined by the top surface of the substrate, i.e. the heterojunctions are not horizontal when the substrate is oriented horizontally. There are two embodiments for obtaining the above features
- Either the substrate comprises a top layer of III-V material, and two openings are present in said top layer, and said openings have been filled with SiGe, to form said source and drain areas. In other words, the upper layer of the III-V substrate comprises two SiGe regions, which form the source and drain areas. The SiGe regions have a given depth (i.e. are embedded in the substrate), and are thus laterally adjacent to III-V material, OR :
- The substrate comprises a top layer of SiGe, and an opening is present in said top layer, and said opening has been filled with III-V material, to form said channel area. In other words, the upper layer of the SiGe substrate comprises a region consisting of III-V material, said region forming the channel area. The III-V region has a given depth (i.e. is embedded in the substrate) and is thus laterally adjacent to SiGe.

### Brief Description of the Drawings

Fig. 1 represents a device according to a first embodiment of the invention.
Fig. 2 represents a device according to a second embodiment of the invention.
Fig. 3 illustrates a device of the invention wherein source and drain areas are subjected to a germanidation.
Fig. 4 represents a graph showing III-V materials which are included in the preferred scope of the invention. Figure 4 is taken from prior art literature.
Fig. 5 represents a specific example of a device According to the first embodiment.
Fig. 6 represents an example of a HEMT device according to the invention.

### Detailed Description of the Invention

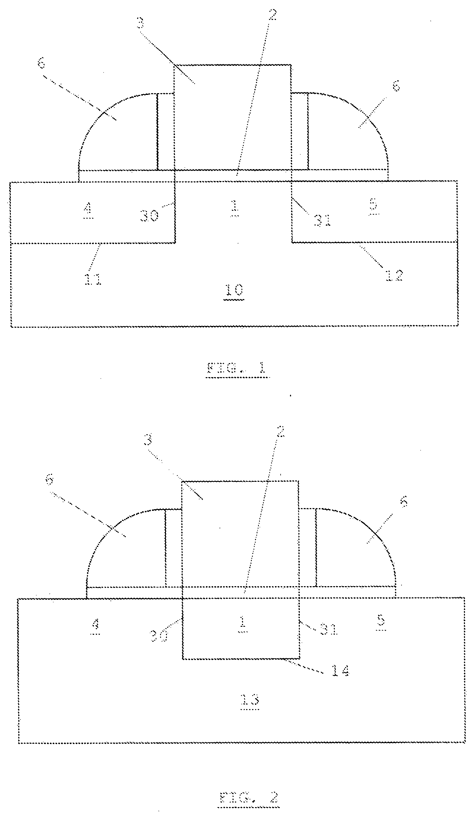

The invention is related to a semiconductor transistor device, for example a MOSFET, such as shown in figures 1 and 2. The figures show only the active area on which one device is built. It is to be understood that field areas surround the device shown in each drawing. A MOSFET according to the invention comprises the classic components, namely a first semiconductor area called the channel 1, located underneath the gate dielectric 2 and gate electrode 3. The channel lies in between two semiconductor areas 4 and 5, called source and drain areas respectively. Spacers 6 are normally present on either side of the gate 3. In the case of a MOSFET, as shown in the drawings, the actual channel is the interface between the top layer (called 'channel layer' in the context of this patent application) in the channel area 1 and the dielectric 2. According to the invention, at least the channel layer of the channel area consists of a III-V material, for example GaAs, while the source and drain areas comprise SiGe, so that a heterojunction (30,31) is formed in each of the border areas between III-V material and SiGe, said heterojunction being arranged so that the current flowing in the channel passes through said heterojunction.

In a HEMT device, the structure is similar to the one shown in figures 1 and 2, but the channel area 1 is built from several layers, designed to obtain a 2-dimensional electron gas in a conducting layer sandwiched between two active layers. The dielectric layer 2 is not necessarily present in a HEMT device. In a HEMT according to the invention, at least one of said active layers (the channel layer) consists of a III-V material, while the source and drain areas comprise SiGe, so that again, a heterojunction is formed in each of the border areas between III-V material and SiGe, said heterojunction being arranged so that the current flowing through the channel passes through said heterojunction. Any device according to the invention is characterized by the presence of a heterojunction between SiGe and III-V material, said heterojunction being arranged so that the current flowing through the channel passes through said heterojunction.

According to the invention, the heterojunctions referred to above are not parallel to the plane of the substrate (i.e. heterojunctions are not horizontal in the appended drawings). According to the embodiments shown in the drawings, the heterojunctions are vertically oriented. According to the invention, the heterojunctions are oriented so as to intersect, i.e. be in physical contact with the gate dielectric 2 or with the gate electrode 3 (when no gate dielectric is present as in a HEMT e.g.). This feature ensures a close proximity of the heterojunctions to the gate and thereby an optimal control by the gate over the barrier properties of the heterojunctions. The gate thus extends over both sides of the heterojunction and controls the tunnelling through the energy barrier of the heterojunction from both sides.

The term 'SiGe' (silicon-germanium) is to be understood in the context of this application as SiₓGe₁₋ₓ, with x between 0 and 100%, so it is a range of materials with differing concentrations of Si and Ge, the included limits being pure Si and pure Ge. This is the way 'SiGe' is generally interpreted by a person skilled in the art of semiconductor technology. Where appropriate, the full expression 'SiₓGe₁₋ₓ' is used, otherwise simply 'SiGe'. Preferred embodiments exclude the use of pure Si in various ranges (respectively, x<100%, <90%, <80% and <70%).

According to a first embodiment, shown in fig. 1, the device of the invention comprises a substrate 10 of III-V material, wherein openings, i.e. cavities 11, 12 have been produced, e.g, by etching, and wherein said openings have been filled with SiGe, to form the source and drain areas 4,5. In other words, the upper layer of the III-V substrate comprises two SiGe regions, which form the source and drain areas 4 and 5. The SiGe regions have a given depth, and are thus laterally adjacent to the III-V material of the channel area.

According to a second embodiment, shown in figure 2, the device comprises a substrate 13 of SiGe, wherein an opening, i.e. a cavity 14 has been produced, e.g. by etching, and wherein said opening has been filled with a III-V material, e.g. GaAs, to form the channel area 1. In other words, the upper layer of the SiGe substrate comprises a region consisting of III-V material, said region forming the channel area 1. The III-V region has a given depth and is thus laterally adjacent to the SiGe of the source and drain areas.

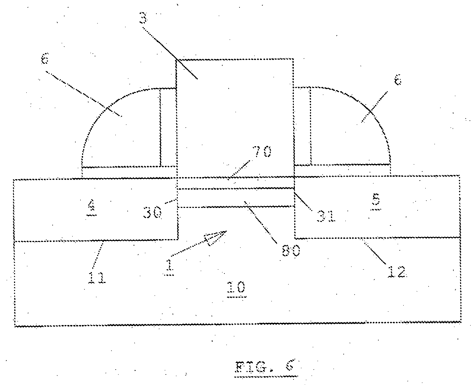

In both cases, the final result is a MOSFET (or a HEMT, fig. 6), comprising a III-V channel 1 and SiGe source and drain areas 4 and 5. In both embodiments, the difficulty of doping the source and drain areas is no longer present, because SiGe can be easily doped by ion-implantation or in-situ doping techniques. Furthermore, SiGe can be easily contacted through various metallization schemes.

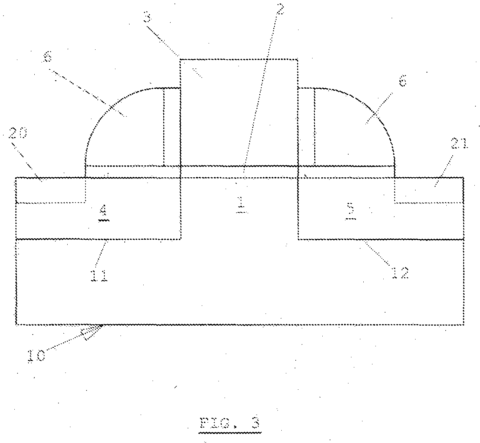

Germanidation and/or silicidation can be used (for example by forming Nickel Germanide - NiGe) on the SiGe regions, to form a region in said source and drain areas, said region consisting of a metal germanide and/or silicide, said region facilitating the contacting of the source and drain. According to an embodiment, after producing source and drain areas in SiGe, as in embodiments 1 and 2, preferably in pure Ge, a layer of a metal, e.g. Ni, is applied on the substrate, so that a region (20, 21) of NiGe is formed near the surface of the substrate, see figure 3. The formation of NiGe preferably occurs by applying a continuous layer of Ni on the totality of the substrate, and allowing NiGe to form on the Ge-regions. After that, the unreacted Ni on the remaining areas is removed by an etching step. This type of self-aligned production of NiGe-areas is known in the art. Other types of metal may be used, in combination with a source/drain area with various concentrations of Si and Ge in the SiₓGe₁₋ₓ areas, to form a metallic region by an alloy of a metal such as Pt, Pt, Co, Ni with the semiconductor material, SiₓGe₁₋ₓ. When x is between 0 and 100 excluding the boundary values, a mixed germanide/silicide compound will be formed with the applied metal.

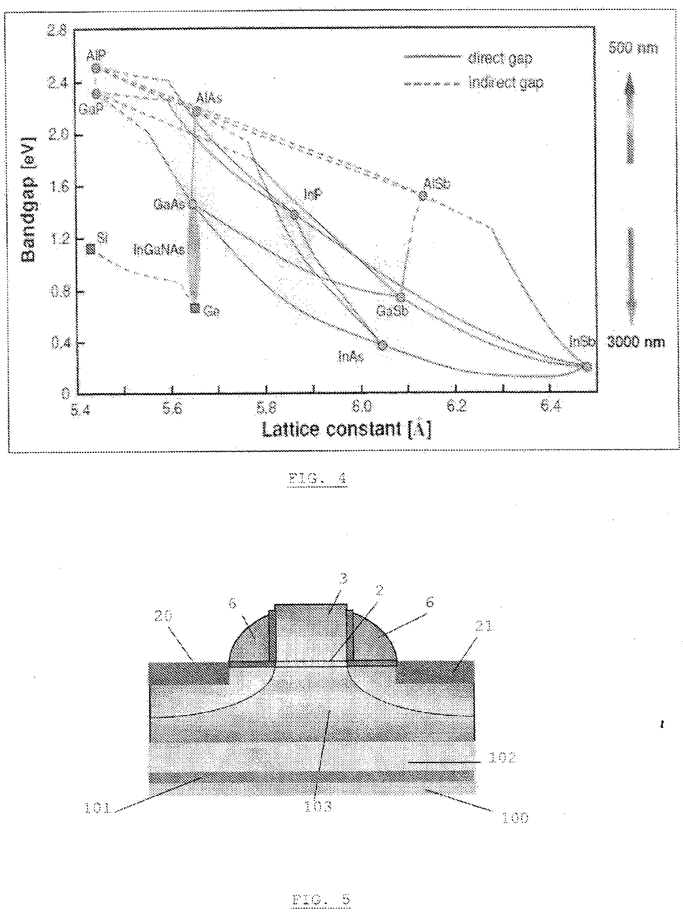

The III-V material used for the channel area 1 is preferably chosen from the list consisting of : GaAs, AlP, GaP, AlAs, InGaNAs, InGaAs, InP and AlSb. These materials have a bandgap above 1eV (fig. 4). The III-V material can also be a mixture of these elements. The channel material can equally be a III-V material with a low bandgap (i.e. <1eV), but that is not the preferred case.

The material of the source and drain 4 and 5 is SiGe, which is actually SiₓGe₁₋ₓ, with x between 0 and 100%, as explained above.

The heterojunctions formed by the SiGe and III/V material will in the case of Germanium and GaAs most likely have a band alignment along the conduction band edge of these materials, making these junctions ideally suited for nMOS applications. Other III/V materials may have similar properties or may alternatively be used for pMOS when band alignment occurs at the valence band edge of these materials.

In the invention, the III-V material and the source/drain material have substantially the same lattice constant. Ideal combinations are therefore : GaAs/Ge or AlAs/Ge, as can be derived from the graph in figure 4. The substrates 10 and 13 can be bulk crystalline GaAs or SiGe substrates, or they can in turn be layers of GaAs or SiGe, applied by a deposition or layer transfer technique on another substrate, for example a silicon wafer. Such substrates are known: germanium-on-insulator (GOI), whereby a crystalline germanium layer upon a dielectric layer is present for growing layers of III/V material or silicon-on-insulator whereby a crystalline silicon layer upon a dielectric is present for growing silicon/germanium and germanium layers upon which layers of III/V material can be formed.

Fig. 5 shows a specific embodiment of a MOSFET according to the first embodiment, comprising on a Si-wafer 100 :
- a graded Si/Ge layer 101, having a low concentration of Ge near the interface with Si, and a growing Ge-concentration while progressing to the opposite side, up to virtually 100% Ge at the top,
- a Ge layer 102, grown by selective epitaxy,
- A III-V layer 103, e.g. GaAs or GaₓIn₁₋ₓAs, grown by selective MOCVD on Ge

The layer 103 is then equivalent to the substrate 10 of figure 1. On this layer 103, the Ge-source and drain 4 and 5 are formed, e.g. by etching of the GaAs and epitaxial growth of Ge on GaAs. The device of figure 5 may also be built on a GeOI substrate (Germanium on Insulator) whereby layer 102 is then formed upon a dielectric layer.

The method of producing a device according to the first embodiment of the invention, comprises the steps of :
- providing a substrate having a top layer consisting of III-V material. This can be a III-V wafer 10, or a Si wafer 100 with a III-V layer 103 deposited on it, possibly with other layers (101, 102) between the Si and the III-V, as shown for example in fig. 5,
- By photolithographic techniques, etching back two cavities 11 and 12 in the III-V layer, to form a channel area 1 in between said cavities,
- Filling up said cavities with SiGe, preferably by a selective deposition technique, e.g. by epitaxial growth, to form source and drain areas 4 and 5 in contact with the channel area 1. Other techniques can be applied to selectively form SiGe in said cavities, e.g. by uniform growth and subsequent removal of the SiGe outside the cavities using photolithographic patterning and etching steps known in the art.

The method of producing a device according to the second embodiment of the invention, comprises the steps of :
- providing a substrate having a top layer consisting of SiGe. This can be a SiGe wafer 13, or a Si wafer with a SiGe layer deposited on it, possibly with other layers between the Si and the SiGe,
- By photolithographic techniques, etching back a cavity 14 in the III-V layer, for forming a channel area 1,
- Filling up said cavity with III-V material, preferably by a selective deposition technique, e.g. by epitaxial growth, to form the channel area 1

The method steps according to both embodiments, can then be followed by steps of doping the SiGe source and drain regions, and producing source, drain and gate contacts, by methods known in the art.

As stated above, the invention is not limited to MOSFET devices. Also in other types of transistors, source and drain areas can be produced in SiGe, to form non-horizontal heterojunctions with e.g. GaAs. This can be the case for example in HEMT transistors (High Electron Mobility Transistor). As mentioned above, in a HEMT transistor, the structure of the III-V layer will be different from the case of a MOSFET, and will comprise multiple layers of III-V material. An example of such a HEMT structure is shown in figure 6. Active layers 70 and 80 are present underneath the gate electrode 3. At least the channel layer 80 is a III-V layer, e.g. a GaN layer. Layer 70 can also be III-V, e.g. AlGaN, as is known in the art. The channel can be formed at the interface between layers 70 and 80. If a third layer is present adjacent layer 80 opposite layer 70 then a two dimensional carrier gas is created in the channel layer 80 thereby forming a conductive path between source 4 and drain 5.

## Claims

1. A semiconductor transistor device comprising :
- a channel area (1), said channel area comprising a channel layer in which charge carriers can move when the transistor is turned on, in order to pass a current through the transistor,
- a source area (4) and a drain area (5), contacting the channel layer for providing current to and from said channel layer,
- a gate electrode (3), preferably provided with a gate dielectric (2) between the gate electrode and the channel layer,
wherein said channel layer consists of a III-V material, and said source and drain areas comprise SiGe, being SiₓGe₁₋ₓ, with x between 0 and 100%, arranged so that heterojunctions (30,31) are present between III-V material and SiGe, said heterojunctions being arranged so that current passes through said heterojunctions, wherein said heterojunctions (30,31) are oriented so as to intersect with said gate dielectric (2) or said gate electrode, and wherein the III/V material and the SiGe have substantially the same lattice constant.

2. The device according to claim 1, wherein said substrate comprises a top layer (10) of said III-V material, and wherein two openings (11,12) are present in said top layer, and wherein said openings have been filled with SiGe, to form said source and drain areas (4,5).

3. The device according to claim 1, wherein said substrate comprises a top layer (13) of SiGe, and wherein an opening (14) is present in said top layer, and wherein said opening has been filled with III-V material, to form said channel area (1).

4. The device according to any one of claims 1 to 3, wherein said III-V material is chosen from the group consisting of GaAs, AlP, GaP, AlAs, InGaNAs, InGaAs, InP and AlSb.

5. The device according to any one of the preceding claims, wherein said source and/or drain area are provided with a contact portion (20,21) consisting of a metal germanide and/or silicide.

6. The device according to any one of the preceding claims, wherein said device is a MOSFET.

7. The device according to any one of the preceding claims, wherein said device is a HEMT.

8. A method for producing a device according to claim 2, said method comprising the steps of :
- providing a substrate having a top layer (10) consisting of a III-V material,
- By a photolithographic technique, etching back two cavities (11,12) in the III-V layer, to form a channel area (1) in between said cavities,
- Filling up said cavities with SiGe, to form source and drain areas (4,5) in contact with the channel area (1).

9. A method for producing a device according to claim 3, said method comprising the steps of :
- providing a substrate (13) having a top layer consisting of SiGe,
- By a photolithographic technique, etching back a cavity (14) in the SiGe layer, for forming a channel area (1),
- Filling up said cavity (14) with III-V material, to form the channel area (1).

10. A device according to claim 1, wherein x is smaller than 100%.

11. A device according to claim 1, wherein x is smaller than 90%.

12. A device according to claim 1, wherein x is smaller than 80%.

13. A device according to claim 1, wherein x is smaller than 70%.

## Patentansprüche

1. Halbleitertransistorvorrichtung, umfassend:
- einen Kanalbereich (1), wobei der Kanalbereich eine Kanalschicht umfasst, in der sich Ladungsträger bewegen können, wenn der Transistor eingeschaltet ist, um einen Strom durch den Transistor zu leiten,
- einen Quellen-Bereich (4) und einen Drain-Bereich (5) in Kontakt mit der Kanalschicht zur Bereitstellung von Strom für die Kanalschicht und zur Ableitung von Strom von dieser,
- eine Gate-Elektrode (3), die vorzugsweise mit einem Gate-Dielektrikum (2) zwischen der Gate-Elektrode und der Kanalschicht ausgestattet ist,
wobei die Kanalschicht aus einem III-V-Material besteht und die Quellen- und Drain-Bereiche SiGe umfassen, das SiₓGe₁₋ₓ ist, wobei x zwischen 0 und 100 % liegt, und so angeordnet ist, dass Heteroübergänge (30, 31) zwischen III-V-Material und SiGe vorhanden sind, wobei die Heteroübergänge so angeordnet sind, dass Strom durch die Heteroübergänge geleitet wird, wobei die Heteroübergänge (30, 31) so orientiert sind, dass sie sich mit dem Gate-Dielektrikum (2) oder der Gate-Elektrode kreuzen, und wobei das III/V-Material und das SiGe im Wesentlichen dieselbe Gitterkonstante haben.

2. Vorrichtung nach Anspruch 1, wobei das Substrat eine Deckschicht (10) aus dem III-V-Material umfasst, und wobei zwei Öffnungen (11, 12) in der Deckschicht vorhanden sind, und wobei die Öffnungen mit SiGe gefüllt sind, um die Quellen- und Drain-Bereiche (4, 5) zu bilden.

3. Vorrichtung nach Anspruch 1, wobei das Substrat eine Deckschicht (13) aus SiGe umfasst, und wobei eine Öffnung (14) in der Deckschicht vorhanden ist, und wobei die Öffnung mit III-V-Material gefüllt ist, um den Kanalbereich (1) zu bilden.

4. Vorrichtung nach einem der Ansprüche 1 bis 3, wobei das III-V-Material ausgewählt ist aus der Gruppe bestehend aus GaAs, AlP, GaP, AlAs, InGaNAs, InGaAs, InP und AlSb.

5. Vorrichtung nach einem der vorhergehenden Ansprüche, wobei der Quellen- und/oder Drain-Bereich mit einem Kontaktteil (20, 21) ausgestattet sind, das aus einem Metallgermanid und/oder -silicid besteht.

6. Verfahren nach einem der vorhergehenden Ansprüche, wobei die Vorrichtung ein MOSFET ist.

7. Verfahren nach einem der vorhergehenden Ansprüche, wobei die Vorrichtung ein HEMT ist.

8. Verfahren zur Herstellung einer Vorrichtung nach Anspruch 2, wobei das Verfahren die folgenden Schritte umfasst:
- Bereitstellen eines Substrats mit einer Deckschicht (10), die aus einem III-V-Material besteht,
- wobei nach einer Fotolithografietechnik zwei Hohlräume (11, 12) in der III-V-Schicht rückgeätzt werden, um einen Kanalbereich (1) zwischen den beiden Hohlräumen zu bilden,
- Auffüllen der Hohlräume mit SiGe, um Quellen- und Drain-Bereiche (4, 5) in Kontakt mit dem Kanalbereich (1) zu bilden.

9. Verfahren zur Herstellung einer Vorrichtung nach Anspruch 3, wobei das Verfahren die folgenden Schritte umfasst:
- Bereitstellen eines Substrats (13) mit einer Deckschicht, die aus SiGe besteht,
- wobei nach einer Fotolithografietechnik ein Hohlraum (14) in der SiGe-Schicht rückgeätzt wird, um einen Kanalbereich (1) zu bilden,
- Auffüllen des Hohlraums (14) mit III-V-Material, um den Kanalbereich (1) zu bilden.

10. Vorrichtung nach Anspruch 1, wobei x kleiner als 100 % ist.

11. Vorrichtung nach Anspruch 1, wobei x kleiner als 90 % ist.

12. Vorrichtung nach Anspruch 1, wobei x kleiner als 80 % ist.

13. Vorrichtung nach Anspruch 1, wobei x kleiner als 70 % ist.

## Revendications

1. Dispositif de transistor à semi-conducteur comprenant :
- une région de canal (1), ladite région de canal comprenant une couche de canal dans laquelle des porteurs de charge peuvent se déplacer lorsque le transistor est mis à l'état passant, afin de laisser passer un courant à travers le transistor,
- une région de source (4) et une région de drain (5), en contact avec la couche de canal pour fournir un courant vers et à partir de ladite couche de canal,
- une électrode de grille (3), pourvue, de préférence, d'un diélectrique de grille (2) entre l'électrode de grille et la couche de canal,
dans lequel ladite couche de canal consiste en un matériau III-V, et lesdites régions de source et de drain comprennent du SiGe, qui est du SiₓGe₁₋ₓ, avec x entre 0 et 100 %, agencés de sorte que des hétérojonctions (30, 31) sont présentes entre le matériau III-V et le SiGe, lesdites hétérojonctions étant agencées de sorte qu'un courant passe à travers lesdites hétérojonctions, dans lequel lesdites hétérojonctions (30, 31) sont orientées de manière à croiser ledit diélectrique de grille (2) ou ladite électrode de grille, et dans lequel le matériau III-V et le SiGe ont sensiblement la même constante de réseau.

2. Dispositif selon la revendication 1, dans lequel ledit substrat comprend une couche supérieure (10) dudit matériau III-V, et dans lequel deux ouvertures (11, 12) sont présentes dans ladite couche supérieure, et dans lequel lesdites ouvertures ont été remplies de SiGe, pour former lesdites régions de source et de drain (4, 5).

3. Dispositif selon la revendication 1, dans lequel ledit substrat comprend une couche supérieure (13) de SiGe, et dans lequel une ouverture (14) est présente dans ladite couche supérieure, et dans lequel ladite ouverture a été remplie du matériau III-V, pour former ladite région de canal (1).

4. Dispositif selon l'une quelconque des revendications 1 à 3, dans lequel ledit matériau III-V est choisi dans le groupe consistant en le GaAs, l'AlP, le GaP, l'AlAs, l'InGaNAs, l'InGaAs, l'InP et l'AlSb.

5. Dispositif selon l'une quelconque des revendications précédentes, dans lequel lesdites régions de source et/ou de drain sont pourvues d'une partie de contact (20, 21) consistant en un germaniure et/ou un siliciure métallique.

6. Dispositif selon l'une quelconque des revendications précédentes, dans lequel ledit dispositif est un MOSFET.

7. Dispositif selon l'une quelconque des revendications précédentes, dans lequel ledit dispositif est un HEMT.

8. Procédé pour produire un dispositif selon la revendication 2, ledit procédé comprenant les étapes :
- de fourniture d'un substrat comportant une couche supérieure (10) consistant en un matériau III-V,
- par une technique photolithographique, de gravure en retrait de deux cavités (11, 12) dans la couche III-V, pour former une région de canal (1) entre lesdites cavités,
- de remplissage desdites cavités avec du SiGe, pour former des régions de source et de drain (4, 5) en contact avec la région de canal (1).

9. Procédé pour produire un dispositif selon la revendication 3, ledit procédé comprenant les étapes :
- de fourniture d'un substrat (13) comportant une couche supérieure consistant en du SiGe,
- par une technique photolithographique, de gravure en retrait d'une cavité (14) dans la couche de SiGe pour former une région de canal (1),
- de remplissage de ladite cavité (14) avec un matériau III-V pour former la région de canal (1).

10. Dispositif selon la revendication 1, dans lequel x est inférieur à 100 %.

11. Dispositif selon la revendication 1, dans lequel x est inférieur à 90 %.

12. Dispositif selon la revendication 1, dans lequel x est inférieur à 80 %.

13. Dispositif selon la revendication 1, dans lequel x est inférieur à 70 %.
